# EUROPÄISCHE PATENTSCHRIFT

(11) **EP 1 057 388 B1**
(45) Veröffentlichungstag und Bekanntmachung des Hinweises auf die Patenterteilung: **17.10.2001**
(21) Anmeldenummer: 99903530.6
(22) Anmeldetag: 12.02.1999
(51) Int. Cl.: H05K 13/04, H01L 21/00

(54) **EINRICHTUNG ZUM POSITIONIEREN VON AUF EINER FOLIE ANGEORDNETEN ELKTRONISCHEN SCHALTUNGEN**
DEVICE FOR POSITIONING ELECTRONIC CIRCUITS ARRANGED ON A FOIL
DISPOSITIF POUR POSITIONNER DES CIRCUITS ELECTRONIQUES PLACES SUR UNE FEUILLE

(30) Priorität: 17.02.1998 AT 27998; 13.03.1998 AT 45398
(43) Veröffentlichungstag der Anmeldung: 06.12.2000
(73) Patentinhaber: Datacon Semiconductor Equipment GmbH, 6240 Radfeld (AT)
(72) Erfinder: SCHWEITZER, Karl, A-6300 Angerberg (AT)
(74) Vertreter: Krause, Peter
(86) Internationale Anmeldenummer: AT9900037
(87) Internationale Veröffentlichungsnummer: WO9943192

(56) Entgegenhaltungen:
- DE-A- 19 610 294
- PATENT ABSTRACTS OF JAPAN vol. 014, no. 225 (E-0927), 14. Mai 1990 -& JP 02 056944 A (MATSUSHITA ELECTRIC IND CO LTD), 26. Februar 1990

## Beschreibung

Die Erfindung betrifft eine Einrichtung zum Positionieren von auf einer Folie angeordneten elektronischen Schaltungen, insbesondere Chips, auf einer Leiterplatte, insbesondere einem Keramiksubstrat entsprechend der Flip-Chip-Methode, wobei die Schaltungen mittels unter der Folie angeordneter Ausstechnadeln von der Folie abgehoben werden und von einer Saugnade erfaßt und 180° geschwenkt, von einer weiteren Saugnadel übernommen und auf der Leiterplatte zum direkten Verbinden der Kontaktbahnen positioniert werden.

Normalerweise werden die elektronische Schaltung bzw. der Chip mit der den Kontakten abgewandten Seite auf der Leiterplatte angebracht und die Kontakte und die Kontaktbahnen mit Mikrodrähten verbunden. Die Verbindung der Drähte mit den Kontakten erfolgt beispielsweise durch Ultraschallschweißen. Dieses Verfahren wird auch als Drahtbonden bezeichnet. Die Nachteile dieser Methode liegen auf der Hand. Einerseits waren viele Arbeitsgänge zur Herstellung der fertigen Platine notwendig, anderseits sind durch diese Art und Weise der Chipbefestigung die Streueinflüsse schwer zu beherrschen.

Eine Alternative zum Drahtbonden ist die Flip-Chip-Methode. Dabei werden die Kontakte des Chip direkt, wie eingangs aufgezeigt, mit den Kontaktbahnen der Leiterplatte verbunden. Bei dieser Methode ist eine höhere Kontaktsicherheit, ein kürzerer Verbindungsweg, speziell bei hohen Frequenzen, und der Entfall des aufwendigen Drahtbondens gegeben. Um die unterschiedlichen Dehnungskoeffizienten auszugleichen, wird der Hohlraum zwischen Chip und Leiterplatte nach dem Kontaktieren mit Kleber bzw. Füllstoff ausgefüllt.

Wichtig ist bei diesem Verfahren, daß die Kontakte von Chip und Leiterplatte exakt übereinanderliegen. Um das zu erreichen, müssen die Lage jedes Chips und jeder Leiterplatte vermessen und eine Korrekturbewegung berechnet werden. Wenn die Geometrie der Leiterplatte genau genug ist, reicht es zwei Referenzpunkte der Leiterplatte zu vermessen und die einzelnen Ablagepositionen umzurechnen. Andernfalls wird jede einzelne Ablageposition einzeln vermessen.

Das im Recherchenbericht genannte Dokument DE-A-196 10 294 betrifft eine Positioniereinrichtung, die einen um 90° schwenkbaren Rotationsbestückkopf aufweist. Das Dokument PATENT ABSTRACTS OF JAPAN vol. 014, no. 225 (E-0927), 14. Mai 1990 -& JP 02 056944 A (MATSUSHITA ELECTRIC IND CO LTD), 26. Februar 1990, offenbart eine Montagevorrichtung für elektronische Bauteile, wobei ein Sauger vorgesehen ist, der eine 180°-Schwenkbewegung ausführt und ein weiterer Sauger das Bauteil nach der Schwenkbewegung übernimmt.

Besonders schwierig ist die Programmierung der Sollposition eines Chips, da eine visuelle Korrektur des Ergebnisses nicht möglich ist. Die Strukturen von Chip und Leiterplatte liegen nämlich übereinander. Die Genauigkeit, mit der die Kontakte übereinander liegen, kann nur über zerstörende Methoden geprüft werden.

Aufgabe der Erfindung ist es daher, eine Einrichtung der eingangs genannten Art zu schaffen, die einerseits die Nachteile des Standes der Technik vermeidet und die anderseits einen hohen Bedienungskomfort durch Programmierbarkeit und Reproduzierbarkeit der diversen Einstellungen aufweist und sich durch einen einfachen Aufbau auszeichnet.

Die erfindungsgemäße Einrichtung ist dadurch gekennzeichnet, daß sowohl die Ausstechnadeln zum Abheben der Schaltung von der Folie, wie auch die Saugnadel zur Übernahme, eine synchrone, insbesondere eine geradlinige bzw. senkrechte Bewegung ausführen, daß die Saugnadel in einer Saugnadelhalterung, die in einem Arm beweglich gelagert ist, vorgesehen ist und dieser Arm über einen Antrieb für die 180°-Drehbewegung antreibbar ist und daß die weitere Saugnadel ebenfalls in einer Saugnadelhalterung gelagert ist, die der Saugnadel vier Bewegungsfreiheiten, nämlich in x, y und z-Richtung und Drehen gewährt.

Mit der Erfindung ist es erstmals möglich, sowohl die 180°-Drehung, wie auch die vertikale Chipabnahmebewegung mit einem Motor zu realisieren und die Chipabnahmebewegung so zu steuern, daß sie synchron zur Bewegung der

Ausstechnadeln ist. Dieser synchrone Ausstechvorgang stellt einen entscheidenden Qualitätsvorteil dar, da der Chip dabei, während des gesamten Vorganges, mit konstanter Kraft zwischen den Ausstechnadein und der Saugnadel festgehalten wird. Außerdem kommt es dabei nie zu einer horizontalen Relativbewegung zwischen den Ausstechnadeln und der Saugnadel, die die Chipoberfläche unweigerlich zerstören würde.

Ferner ist es mit der Erfindung möglich, eine maschinelle Einrichtung für eine äußerst rationelle Fertigung bzw. für eine Erhöhung des Automatisierungsgrades in der Leiterplattenbestückung herzustellen. Darüber hinaus ist es mit der Erfindung möglich, die Qualität der derart hergestellten Leiterplatten enorm zu erhöhen. Ein weiterer gravierender Vorteil ist darin zu sehen, daß der Aufbau der erfindungsgemäßen Einrichtung durch die Anordnung nur eines Antriebes für den Bewegungsablauf zum Positionieren des Chips sehr einfach und dadurch auch wirtschaftlich ist. Durch die Bewegungsfreiheit der zweiten Saugnadel ist eine qualitativ hochstehende Positionierung des Chips auf der Leiterplatte gewährleistet.

Nach einem besonderen Merkmal der Erfindung sind zwei Vermessungskameras vorgesehen, wobei eine Vermessungskamera zum Vermessen der Leiterplatte und die zweite Vermessungskamera zum Vermessen des Chips dient und beide Vermessungskameras an einen Rechner angeschlossen sind und die Kalibrierung der beiden Vermessungskameras durch Überblenden der beiden Bilder auf Deckung erfolgt und diese kalibrierte Position in einem Rechner speicherbar ist. Durch die beiden Vermessungskameras ist eine weitere Qualitätserhöhung zu erreichen. Jede Leiterplatte bzw. jedes Substrat wird fix positioniert und über eine Vermessungskamera an zwei Punkten vermessen. Dabei kann es bereits zu einer Differenz zum programmierten, ursprünglichen Substrat kommen. Die erfaßten, definitiven Werte der Leiterplatte werden in den Rechner eingegeben und gespeichert. Die zweite Vermessungskamera vermißt jeden Chip, wobei auch diese Werte in den Rechner eingegeben werden.

Natürlich ist auch die kalibrierte Position, die durch Überblenden der beiden Bilder erfolgt, im Rechner gespeichert.

Gemäß einer Weiterbildung der Erfindung errechnet bzw. stellt der Rechner nach einer Vermessung eines Chips eine eventuelle Abweichung von der kalibrierten Position fest und steuert die weitere Saugnadel entsprechend der Differenz an. Durch die Vermessung bzw. Erfassung der Chipdaten über die zweite Vermessungskamera und die entsprechende Auswertung über eine geeignete Software ist eine Programmierhilfe für die Positionierung des Chips auf der Leiterplatte gegeben. Entsprechend der im Rechner errechneten Werte wird die zweite Saugnadel angesteuert. Von Vorteil ist dabei vor allem die Programmierbarkeit der Steuerung für die Einrichtung, wobei beispielsweise der Weg, die Geschwindigkeit und / oder der Zeitpunkt o.dgl. programmierbar ist. Weiters ist von immensen Vorteil, daß alle Werte bzw. Daten, insbesondere über die Rechneranlage, reproduzierbar sind. Die Reproduzierbarkeit der Einstellungen ist in einer derart hochspezialisierten Technologie eine unabdingbare Notwendigkeit, vor allem auch um eine einwandfreie Qualität sicherzustellen.

Wie bereits erwähnt, ist die Programmierung der Sollposition eines Chips gemäß dem Stand der Technik besonders schwierig, da eine visuelle Korrektur des Ergebnisses nicht möglich ist. Um nun diesen Vorgang für den Bediener möglichst einfach zu gestalten, wurde das erfindungsgemäße Verfahren entwickelt, mit dem es genügt, das Bild, das die Kamera von der Chipstruktur aufgenommen hat und das überblendete Bild der Leiterbahnen der weiteren Kamera in Deckung zu bringen. Aus diesem Vorgang ermittelt der Rechner selbständig die Sollposition der Chipablage.

Nach einer besonderen Ausgestaltung der Erfindung ist als Antrieb für die 180°-Drehbewegung des Armes ein Schrittmotor vorgesehen. Vorteilhaft dabei ist, daß ein Schrittmotor einerseits eine ausgereifte Antriebskomponente, die zudem sehr wartungsarm ist, darstellt und anderseits sehr genau mit kleinsten Maßeinheiten steuerbar ist.

Nach einer weiteren Ausgestaltung der Erfindung ist der Arm radial auf einer Welle angeordnet, wobei diese Welle in einer konzentrischen Hohlwelle gelagert ist und die Hohlwelle mit einem Schlitz für den Durchtritt des Armes versehen ist, der einen größeren Winkel als 180°, vorzugsweise 191°, aufweist und die Hohlwelle über einen Riementrieb vom Schrittmotor antreibbar ist. Durch den größeren Winkel als 180° ist vorteilhafterweise gewährleistet, daß bei der Übernahme des Chips von der Folie eine senkrechte Bewegung der Saugnadel ausgeführt werden kann. Ferner ist durch die Anordnung des Armes auf einer Welle, die wiederum in einer Hohlwelle gelagert ist, eine einfache und funktionssichere Konstruktion gegeben.

Gemäß einer besonderen Ausgestaltung der Erfindung weisen sowohl die Welle als auch die Hohlwelle einen radialen Bolzen auf, wobei der Bolzen der Welle durch den Schlitz bzw. eine Ausnehmung in der Hohlwelle ragt und diese beiden Bolzen über eine Zugfeder miteinander verbunden sind. Der Vorteil dieser Ausgestaltung ist darin zu sehen, daß durch die technisch einfachen Bauteile ein zuverlässiger und wartungsarmer Betrieb gewährleistet ist.

Nach einem weiteren Merkmal der Erfindung führt der auf der Welle angeordnete radiale Arm eine durch Anschläge begrenzte exakte 180°-Drehbewegung aus. Für die exakte Übergabe des Chips, einerseits von den Ausstechnadeln zu Saugnadel und anderseits von Saugnadel zu Saugnadel, ist die genaue 180°-Drehbewegung eine vorteilhafte Grundforderung, die einen reibungslosen Ablauf garantiert.

Gemäß einer Weiterbildung der Erfindung weist die Hohlwelle einen weiteren Radialbolzen auf und die Saugnadelhalterung ist mit einem Anschlag versehen, wobei der Radialbolzen in der waagrechten Stellung des Armes an diesem Anschlag anliegt.
Dadurch kann vorteilhafterweise mit einer einfachen Konstruktion die geradlinige, exakte senkrechte Bewegung der Saugnadel gesteuert durchgeführt werden.

Nach einem weiteren Merkmal der Erfindung ist die Saugnadelhalterung in dem Arm beweglich, gegen die Kraft einer Feder, gelagert. Mit dieser Ausgestaltung ist der Vorteil gegeben, daß mit technisch einfachsten Bauteilen ein hochtechnisierter Arbeitsablauf durchgeführt werden kann.

Nach einem weiteren Merkmal der Erfindung ist die Saugnadelhalterung in dem Arm beweglich gelagert, wobei eine Feder vorgesehen ist, die einerseits mit der Saugnadelhalterung und anderseits mit dem Radialbolzen verbunden ist. Mit dieser Ausgestaltung ist der Vorteil gegeben, daß mit technisch einfachsten Bauteilen ein hochtechnisierter Arbeitsablauf durchgeführt werden kann. Vor allem kann über den Winkel den der Radialbolzen ausführt, wenn der Arm am Anschlag aufliegt, also der über 180° hinausgehende Winkel, die auf den Chip von der Saugnadel wirkende Kraft genau definiert werden. Dies ist von Vorteil, da es praktisch eine technologische Notwendigkeit ist, bei größeren Chips eine größere, Kraft aufzubringen als bei kleinen Chips. Ferner ist auch die definierte Kraftaufbringung vorteilhaft, wenn verschiedene Werkzeuge verwendet werden. Bei einem Werkzeug aus Gummi wird eine größere Kraft Anwendung finden, als wenn ein Stahlwerkzeug zum Einsatz kommt. Darüber hinaus kann während des Ausstechvorganges die auf den Chip wirkende Kraft weitgehenst konstant gehalten werden.

Nach einer vorteilhaften Weiterbildung ist die Feder eine Zugfeder. Dadurch ist der Vorteil gegeben, daß der Abstand zwischen dem Radialbolzen und dem Anschlag an der Saugnadelhalterung an dem der Radialbolzen anliegt, praktisch null ist. Dadurch bleibt aber auch die Feder immer gleich lang, so daß eine konstante Kraft gegeben ist.

Gemäß einer Weiterbildung der Erfindung ist die Hohlwelle entgegen der Kraft der Zugfeder weiterverdrehbar. Durch das Antreiben der Hohlwelle über den Schrittmotor ist eine genaue und einwandfreie Steuerung der Bewegung möglich, wobei die Zugfeder dem Grundstreben der Erfindung nach Einfachheit, Zuverlässigkeit und Wirtschaftlichkeit entgegenkommt.

Die Erfindung wird anhand von Ausführungsbeispielen, die in den Zeichnungen dargestellt sind, näher erläutert.
- Fig. 1: zeigt in einer Prinzipskizze die Einrichtung,
- Fig. 2a bis 2d: den Bewegungsablauf der Saugnadel und
- Fig. 3a bis 3d: den Bewegungsablauf der Saugnadel bei einer Federanordnung an der Saugnadelhalterung.

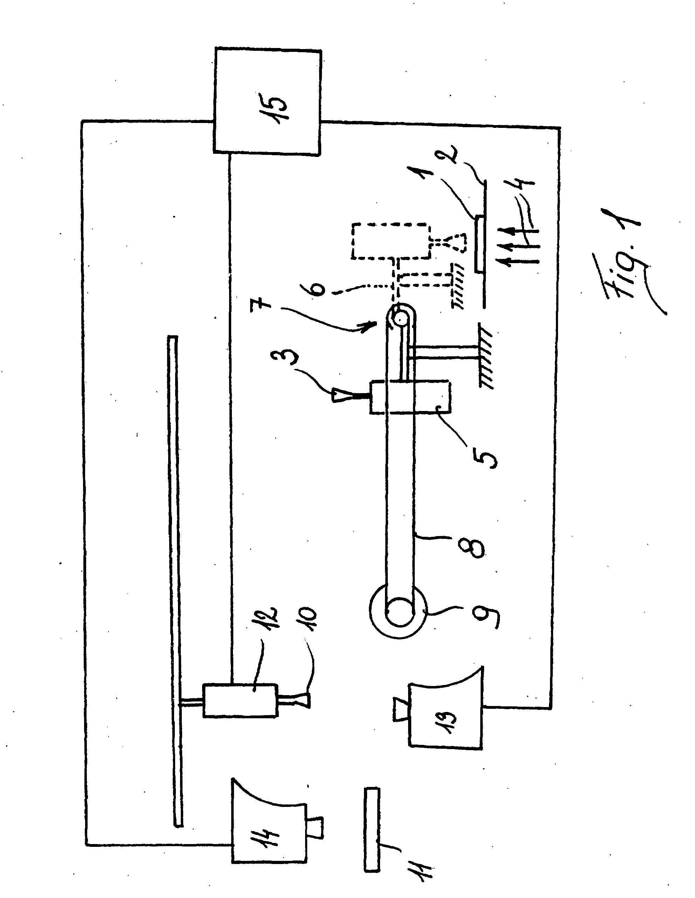

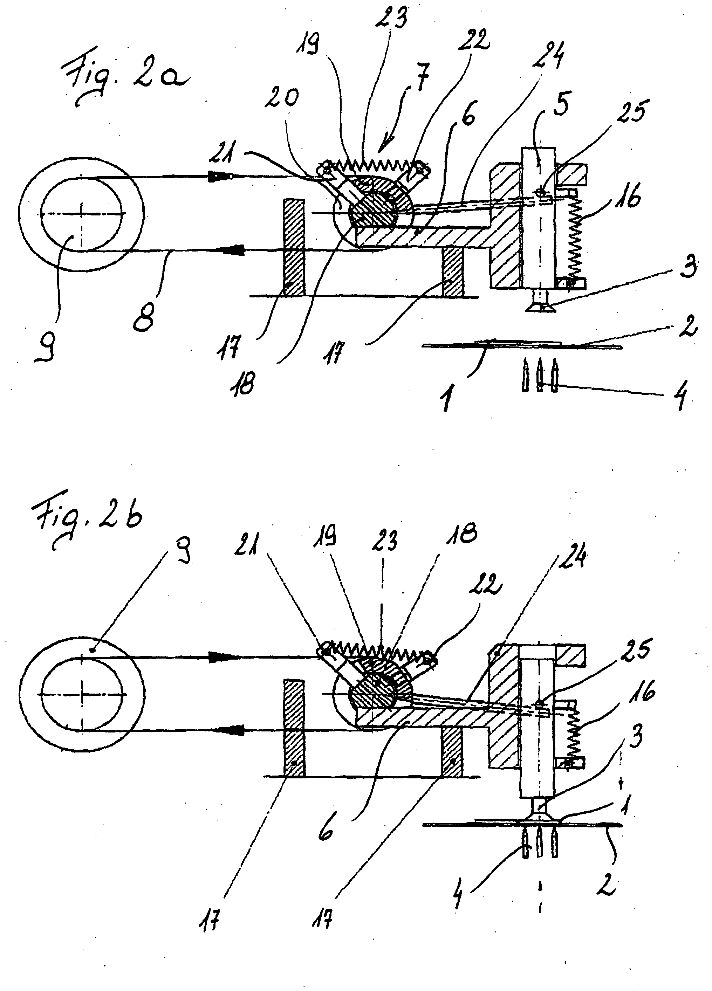

Gemäß der Fig. 1 weist die Einrichtung zum Positionieren von elektronischen Schaltungen, im allgemeinen Chips 1 genannt, einen - nicht dargestellten-Maschinenrahmen auf, auf dem die nachstehend aufgezeigten Bauteile, entsprechend ihrer Funktion fix oder beweglich angeordnet sind.

Bei der Flip-Chip- Methode werden die Chips 1, die auf einer Folie 2 aufgebracht sind, im Zugriffsbereich einer Saugnadel 3 angeordnet. Unter der Folie 2 mit den Chips 1 ist eine Vorrichtung mit Ausstechnadeln 4 vorgesehen. Zum Abheben des Chips 1 von der Folie 2 durchstechen die Ausstechnadeln die Folie 2, wobei die Saugnadel 3 - in dieser Stellung strichliert dargestellt - an der gegenüberliegenden Seite des Chips 1 aufliegt. Das Abheben des Chips 1 erfolgt über eine exakte, geradlinige, senkrechte und synchrone Bewegung von Ausstechnadeln 4 und Saugnadel 3, wobei dies über eine exakte Vertikalbewegung - wie sie später beschrieben wird - erfolgt. Die Saugnadel 3 ist in einer Saugnadelhalterung 5 angeordnet, wobei diese Saugnadelhalterung 5 in einem Arm 6 gelagert ist. Nach der Übernahme des Chip 1 durch die Saugnadel 3 von der Folie 2, wird die Saugnadel 3, vorzugsweise um eine Horizontalachse 180° geschwenkt. Die Schwenk- bzw. Drehbewegung erfolgt über eine Drehmechanik 7 die über einen Riementrieb 8 mit einem Antrieb 9 verbunden ist. Der Chip 1 wird nun von einer weiteren Saugnadel 10 zum Positionieren auf einem Substrat, insbesondere Keramiksubstrat bzw. einer Leiterplatte 11 übernommen. Die Saugnadel 10 ist ebenfalls in einer Saugnadelhalterung 12 vorgesehen, wobei diese Saugnadelhalterung 12 der Saugnadel 10 vier Bewegungsfreiheiten gewährt. Die vier Bewegungsfreiheiten sind die x, y und z-Richtung sowie Drehen. Diese vier Bewegungsfreiheiten sind für das Positionieren des Chip 1 auf der Leiterplatte 11 erforderlich. Darüber hinaus hat jede Saugnadel 3, 10 in ihrer Saugnadelhalterung 5, 12 einen vertikalen Federweg, um ganz weich den Chip 1 aufnehmen bzw. übergeben zu können.

Vor dem Positionieren des Chip 1 auf der Leiterplatte 11 wird der Chip 1 von einer Vermessungskamera 13 vermessen. Ebenso wird vorher die Leiterplatte 11 über die Vermessungskamera 14 vermessen. Beide Vermessungskameras 13, 14 sind an einen Rechner 15 angeschlossen, wobei dieser die vermessenen Daten speichert.

Eine Kalibrierung der beiden Vermessungskameras 13, 14 erfolgt durch Überblenden der beiden Bilder, wobei diese kalbrierte Position im Rechner 15 gespeichert wird. Durch die Vermessung des Chip 1 mit der Vermessungskamera 13 wird im Rechner 15 eine eventuelle Abweichung von der kalibrierten Position errechnet bzw. festgestellt. Über den Rechner 15 wird nun die Saugnadel 10 entsprechend der Differenz gesteuert und der Chip 1 auf der Leiterplatte 11 positioniert. Die im Rechner 15 hinterlegte Software dient also als Programmierhilfe.

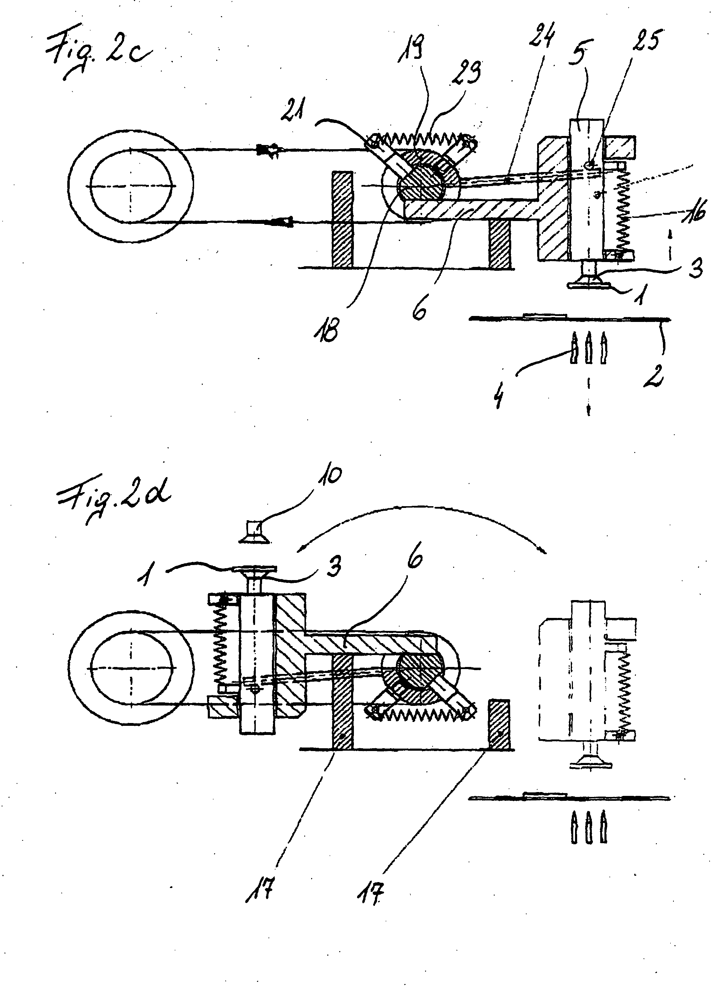

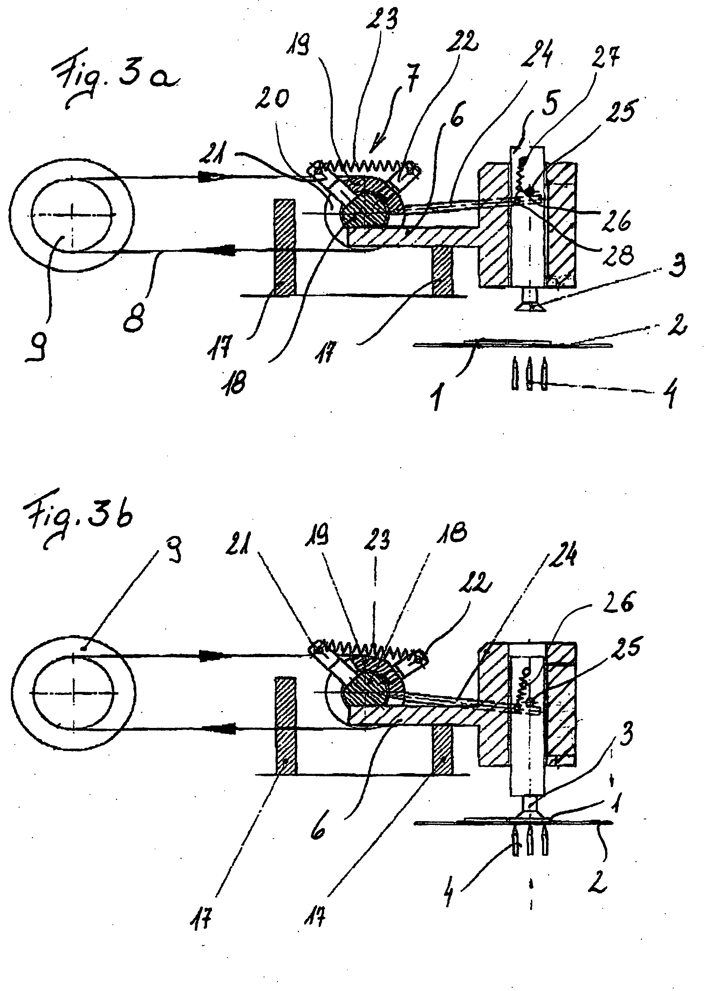

Gemäß der Fig. 2a bis 2d ist der Bewegungsablauf der Saugnadel 3 von der Chipaufnahme bis zur Übergabe an die zweite Saugnadel 10 aufgezeigt.

Gemäß der Fig. 2a ist die Saugnadel 3 in der Saugnadelhalterung 5 angeordnet, wobei die Saugnadelhalterung 5 im Arm 6 längsverschieblich gegen den Druck einer Feder 16 gelagert ist. Im Zugriffsbereich der Saugnadel 3 ist die Folie 2 mit den auf ihr angeordneten Chips 1 vorgesehen, wobei auf der der Saugnadel 3 abgewandten Seite der Folie 2 die Ausstechnadeln 4 angeordnet sind.

Der Arm 6 ist über die Drehmechanik 7 um genau 180° verdrehbar bzw. schwenkbar. Um die genaue 180°- Drehbewegung zu erreichen, sind beiderseits der Schwenkachse je ein Anschlag 17 vorgesehen, die die Drehbewegung des Armes 6 begrenzen. Die Drehmechanik 7 besteht aus einer Welle 18, die in einer konzentrischen Hohlwelle 19 gelagert ist. Auf der Welle 18 ist radial bzw. tangential der Arm 6 befestigt, wobei die Hohlwelle 19 für den Durchtritt des Armes 6 einen Schlitz 20 aufweist. Dieser Schlitz 20 ist derart bemessen, daß der Arm 6 gegenüber der Hohlwelle 19 einen größeren Drehwinkel wie 180° ausführen kann. Insbesondere soll der Arm 6 einen Winkel von 191° gegenüber der Hohlwelle 19 ausführen können. Die Drehung zwischen 180° und 191° wird in eine vertikale Bewegung der Saugnadel 3 umgesetzt. Darüber hinaus weisen sowohl die Welle 18 als auch die Hohlwelle 19 einen radialen Bolzen 21, 22 auf, die mit einer Zugfeder 23 verbunden sind. Der Bolzen 21 der Welle 18 ragt ebenfalls durch den Schlitz 20 der Hohlwelle 19. Natürlich könnte die Hohlwelle 19 auch eine eigene Ausnehmung für den Durchtritt des Bolzens 21 aufweisen. Ferner weist die Hohlwelle 19 einen Radialbolzen 24 auf, der an einem auf der Saugnadelhalterung 5 vorgesehenen Anschlag 25 anliegt. Die Drehmechanik 7 wird über den Riementrieb 8 bewegt, wobei der Riementrieb 8 die Hohlwelle 19 antreibt. Als Antrieb 9 für den Riementrieb 8 wird ein Schrittmotor verwendet.

Anhand der Fig. 2b wird das Abheben eines Chips 1 von der Folie 2 aufgezeigt. Wie bereits eingangs erwähnt, ist für das Abheben des Chips 1 von der Folie 2 eine synchrone Bewegung der Saugnadel 3 und der Ausstechnadeln 4 erforderlich, um während der Abnahme eine konstante Kraft zwischen Ausstechnadeln 4 und Saugnadel 3 zu erhalten. Die exakte Senkrechtbewegung der Ausstechnadeln 4 ist relativ leicht durchzuführen. Um nun eine geradlinige, in diesem Fall senkrechte, Synchronbewegung von der Saugnadel 3 zu den Ausstechnadeln 4 zu erreichen, wird die Hohlwelle 19 nach dem Punkt, wo der Arm 6 am Anschlag 17 anliegt, weiterverdreht, wodurch der Radialbolzen 24 in Richtung der Folie 2 bewegt wird. Gleichzeitig wird die Zugfeder 23 zwischen den Bolzen 21, 22 gespannt. Die Saugnadelhalterung 5, die mit dem Anschlag 25 am Radialbolzen 24 anliegt, wird auf Grund der Kontraktion der Feder 16 in Richtung der Folie 2 auf den Chip 1 bewegt, wo die Saugwirkung der Saugnadel 3 zur Wirkung kommt. Die Ausstechnadeln 4-durchdringen die Folie 2 und liegen am Chip 1 an. Die Drehrichtung des Antriebes 9 wird, durch die Anordnung eines Schrittmotors problemlos, umgedreht.

Gemäß der Fig. 2c wird die Hohlwelle 19 mit dem Radialbolzen 24 entgegen dem Uhrzeigersinn so lange verdreht, bis die Schlitzbegrenzung am Bolzen 21 der Welle 18 anliegt. Die Zugfeder 23 wird entspannt und der Radialbolzen 24 bewegt die Saugnadelhalterung 5 geradlinig, gegen die Kraft der Feder 16 hoch. Synchron dazu werden die Ausstechnadeln 4 geradlinig, bis der Chip 1 sich von der Folie 2 gelöst hat, bewegt. Nach der Übernahme des Chip 1 durch die Saugnadel 3 wird die 180°-Drehbewegung des Armes 6 ausgeführt und die Ausstechnadeln 4 abgesenkt. Die Ausstechnadeln 4 dürfen zu diesem Zeitpunkt keinen Kontakt mehr zur Chiprückseite haben, da der Chip 1 sich durch die 180°-Drehbewegung auf einer Kreisbahn um den Mittelpunkt der Drehachse, also nicht vertikal bewegt. Die Ausstechnadeln 4 würden sonst die Rückseite des Chips 1 beschädigen.

Entsprechend der Fig. 2d liegt der Arm 6 am zweiten Anschlag 17 auf und der Chip 1 kann von der zweiten Saugnadel 10 übernommen werden. Mit der Saugnadel 10 wird der Chip 1 zum Vermessen über die Vermessungskamera 13 gebracht und anschließend entsprechend der rechnerunterstützten Steuerungsdaten auf der Leiterplatte 11 positioniert.

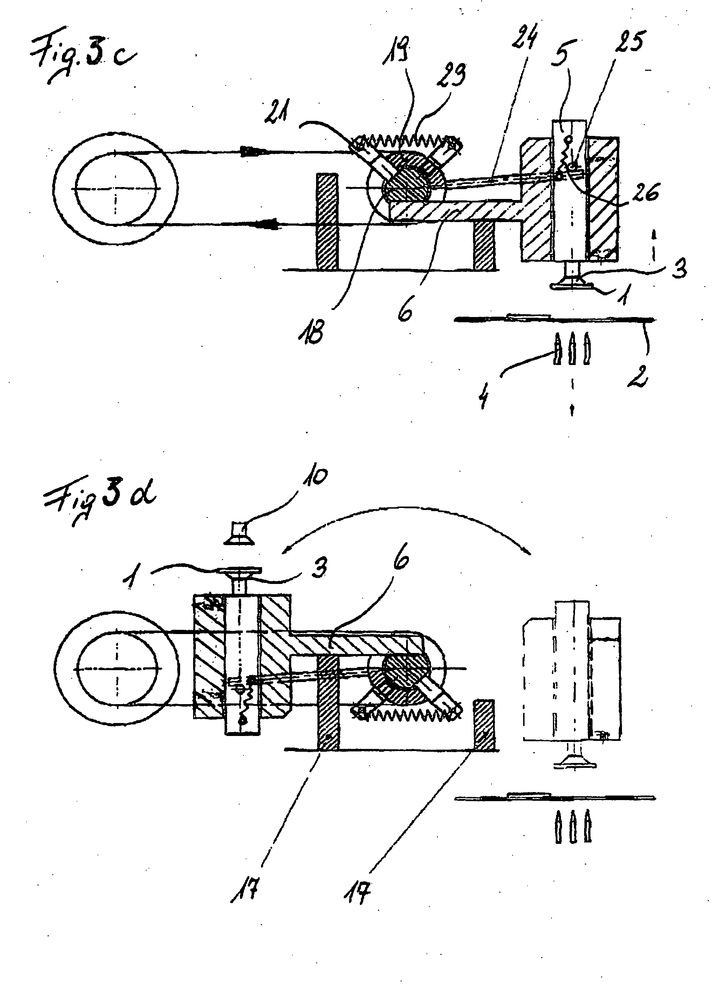

Gemäß der Fig. 3a bis 3d ist der Bewegungsablauf der Saugnadel 3 von der Chipaufnahme bis zur Übergabe an die zweite Saugnadel 10 aufgezeigt.

Gemäß der Fig. 3a ist die Saugnadel 3 in der Saugnadelhalterung 5 angeordnet, wobei die Saugnadelhalterung 5 im Arm 6 längsverschieblich gelagert ist. Im Zugriffsbereich der Saugnadel 3 ist die Folie 2 mit den auf ihr angeordneten Chips 1 vorgesehen, wobei auf der der Saugnadel 3 abgewandten Seite der Folie 2 die Ausstechnadeln 4 angeordnet sind.

Der Arm 6 ist über die Drehmechanik 7 um genau 180° verdrehbar bzw. schwenkbar. Um die genaue 180°- Drehbewegung zu erreichen, sind beiderseits der Schwenkachse je ein Anschlag 17 vorgesehen, die die Drehbewegung des Armes 6 begrenzen. Die Drehmechanik 7 besteht aus einer Welle 18, die in einer konzentrischen Hohlwelle 19 gelagert ist. Auf der Welle 18 ist radial bzw. tangential der Arm 6 befestigt, wobei die Hohlwelle 19 für den Durchtritt des Armes 6 einen Schlitz 20 aufweist. Dieser Schlitz 20 ist derart bemessen, daß der Arm 6 gegenüber der Hohlwelle 19 einen größeren Drehwinkel wie 180° ausführen kann. Insbesondere soll der Arm 6 einen Winkel von 191° gegenüber der Hohlwelle 19 ausführen können. Die Drehung zwischen 180° und 191° wird in eine vertikale Bewegung der Saugnadel 3 umgesetzt. Darüber hinaus weisen sowohl die Welle 18 als auch die Hohlwelle 19 einen radialen Bolzen 21, 22 auf, die mit einer Zugfeder 23 verbunden sind. Der Bolzen 21 der Welle 18 ragt ebenfalls durch den Schlitz 20 der Hohlwelle 19. Natürlich könnte die Hohlwelle 19 auch eine eigene Ausnehmung für den Durchtritt des Bolzens 21 aufweisen. Ferner weist die Hohlwelle 19 einen Radialbolzen 24 auf, der an einem auf der Saugnadelhalterung 5 vorgesehenen Anschlag 25 anliegt. Die Drehmechanik 7 wird über den Riementrieb 8 bewegt, wobei der Riementrieb 8 die Hohlwelle 19 antreibt. Als Antrieb 9 für den Riementrieb 8 wird ein Schrittmotor verwendet.

Die Längsverschieblichkeit der Saugnadelhalterung 5 im Arm 6 wird indirekt über den Radialbolzen 24 bestimmt. Es ist eine Feder 26, insbesondere eine Zugfeder, vorgesehen, die einerseits am Befestigungspunkt 27 am Radialbolzen 24 und anderseits am Befestigungspunkt 28 an der Saugnadelhalterung 5 angelenkt ist.

Anhand der Fig. 3b wird das Abheben eines Chips 1 von der Folie 2 aufgezeigt. Wie bereits eingangs erwähnt, ist für das Abheben des Chips 1 von der Folie 2 eine synchrone Bewegung der Saugnadel 3 und der Ausstechnadeln 4 erforderlich, um während der Abnahme eine konstante Kraft zwischen Ausstechnadeln 4 und Saugnadel 3 zu erhalten. Die exakte Senkrechtbewegung der Ausstechnadeln 4 ist relativ leicht durchzuführen. Um nun eine geradlinige, in diesem Fall senkrechte, Synchronbewegung von der Saugnadel 3 zu den Ausstechnadeln 4 zu erreichen, wird die Hohlwelle 19 nach dem Punkt, wo der Arm 6 am Anschlag 17 anliegt, weiterverdreht, wodurch der Radialbolzen 24 in Richtung der Folie 2 bewegt wird. Gleichzeitig wird die Zugfeder 23 zwischen den Bolzen 21, 22 gespannt. Die Saugnadelhalterung 5, die mit dem Anschlag 25 am Radialbolzen 24 anliegt, wird auf Grund der Kraft der Feder 26 in Richtung der Folie 2 auf den Chip 1 bewegt, wo die Saugwirkung der Saugnadel 3 zur Wirkung kommt. Die Ausstechnadeln 4 durchdringen die Folie 2 und liegen am Chip 1 an. Die Drehrichtung des Antriebes 9 wird, durch die Anordnung eines Schrittmotors problemlos, umgedreht.

Gemäß der Fig. 3c wird die Hohlwelle 19 mit dem Radialbolzen 24 entgegen dem Uhrzeigersinn so lange verdreht; bis die Schlitzbegrenzung am Bolzen 21 der Welle 18 anliegt. Die Zugfeder 23 wird entspannt und der Radialbolzen 24 bewegt die Saugnadelhalterung 5 geradlinig hoch, wobei durch die Kraft der Feder 26 der Anschlag 25 immer am Radialbolzen 24 anliegt. Synchron dazu werden die Ausstechnadeln 4 geradlinig, bis der Chip 1 sich von der Folie 2 gelöst hat, bewegt. Nach der Übernahme des Chip 1 durch die Saugnadel 3 wird die 180°- Drehbewegung des Armes 6 ausgeführt und die Ausstechnadeln 4 abgesenkt. Die Ausstechnadeln 4 dürfen zu diesem Zeitpunkt keinen Kontakt mehr zur Chiprückseite haben, da der Chip 1 sich durch die 180°-Drehbewegung auf einer Kreisbahn um den Mittelpunkt der Drehachse, also nicht vertikal bewegt. Die Ausstechnadeln 4 würden sonst die Rückseite des Chips 1 beschädigen.

Entsprechend der Fig. 3d liegt der Arm 6 am zweiten Anschlag 17 auf und der Chip 1 kann von der zweiten Saugnadel 10 übernommen werden. Mit der Saugnadel 10 wird der Chip 1 zum Vermessen über die Vermessungskamera 13 gebracht und anschließend entsprechend der rechnerunterstützten Steuerungsdaten auf der Leiterplatte 11 positioniert.

Abschließend sei festgehalten, daß in den unterschiedlich beschriebenen Ausführungsbeispielen gleiche Teile mit gleichen Bezugszeichen bzw. mit gleichen Bauteilbezeichnungen versehen sind, wobei in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind bei einer Lageänderung sinngemäß auf die neue Lage zu übertragen.

Die den eigenständigen erfinderischen Lösungen zugrundeliegende Aufgabe kann der Beschreibung entnommen werden.

Der Ordnung halber sei abschließend darauf hingewiesen, daß zum besseren Verständnis des Aufbaus des Antriebes die Bestandteile teilweise unmaßstäblich und/oder vergrößert und/oder verkleinert dargestellt wurden.

## Patentansprüche

1. Einrichtung zum Positionieren von auf einer Folie (2) angeordneten elektronischen Schaltungen (1) insbesondere Chips, auf einer Leiterplatte, insbesondere einem Keramiksubstrat., entsprechend der Flip-Chip-Methode, wobei die Schaltungen mittels unter der Folie angeordneter Ausstechnadeln (4) von der Folie abgehoben werden und von einer Saugnadel (3) erfaßt und 180° geschwenkt, von einer weiteren Saugnadel (10) übernommen und auf der Leiterplatte zum direkten Verbinden der Kontaktbahnen positioniert werden, **dadurch gekennzeichnet, daß** sowohl die Ausstechnadeln (4) zum Abheben der Schaltungen (1) von der Folie (2), wie auch die Saugnadel (3) zur Übernahme, eine synchrone, insbesondere geradlinige bzw. senkrechte Bewegung ausführen, daß die Saugnadel (3) in einer Saugnadelhalterung (5), die in einem Arm (6) beweglich gelagert ist, vorgesehen ist und dieser Arm (6) über einen Antrieb (9) für die 180°-Drehbewegung antreibbar ist und daß die weitere Saugnadel (10) ebenfalls in einer Saugnadelhalterung (12) gelagert ist, die der Saugnadel (10) vier Bewegungsfreiheiten, nämlich in x, y und z-Richtung und Drehen gewährt.

2. Einrichtung nach Anspruch 1, **dadurch gekennzeichnet, daß** zwei Vermessungskameras (13, 14) vorgesehen sind, wobei eine Vermessungskamera (14) zum Vermessen der Leiterplatte (11) und die zweite Vermessungskamera (13) zum Vermessen der Schaltungen (1) dient und beide Vermessungskameras (13, 14) an einen Rechner (15) angeschlossen sind und die Kalibrierung der beiden Vermessungskameras (13, 14) durch Überblenden der beiden Bilder auf Deckung erfolgt und diese kalibrierte Position im Rechner (15) speicherbar ist.

3. Einrichtung nach Anspruch 2, **dadurch gekennzeichnet, daß** der Rechner (15) nach einer Vermessung von Schaltungen (1) eine eventuelle Abweichung von der kalibrierten Position errechnet bzw. feststellt und die weitere Saugnadel (10) entsprechend der Differenz ansteuert.

4. Einrichtung nach einem oder mehreren der Ansprüche 1 bis 3, **dadurch gekennzeichnet, daß** als Antrieb (9) für die 180°-Drehbewegung des Armes (6) ein Schrittmotor vorgesehen ist.

5. Einrichtung nach einem oder mehreren der Ansprüche 1 bis 4, **dadurch gekennzeichnet, daß** der Arm (6) radial auf einer Welle (18) angeordnet ist, wobei diese Welle (18) in einer konzentrischen Hohlwelle (19) gelagert ist und die Hohlwelle (19) mit einem Schlitz (20) für den Durchtritt des Armes (6) versehen ist, der einen größeren Winkel als 180°, vorzugsweise 191°, aufweist und die Hohlwelle (19) über einen Riementrieb (8) vom Schrittmotor antreibbar ist.

6. Einrichtung nach einem oder mehreren der Ansprüche 1 bis 5, **dadurch gekennzeichnet, daß** sowohl die Welle (18) als auch die Hohlwelle (19) einen radialen Bolzen (21, 22) aufweisen , wobei der Bolzen (21) der Welle (18) durch den Schlitz (20) bzw. eine Ausnehmung in der Hohlwelle (19) ragt und diese beiden Bolzen (21, 22) über eine Zugfeder (23) miteinander verbunden sind.

7. Einrichtung nach einem oder mehreren der Ansprüche 1 bis 6, **dadurch gekennzeichnet, daß** der auf der Welle (18) angeordnete radiale Arm (6) eine durch Anschläge (17) begrenzte exakte 180°-Drehbewegung ausführt.

8. Einrichtung nach einem oder mehreren der Ansprüche 1 bis 7, **dadurch gekennzeichnet, daß** die Hohlwelle (19) einen weiteren Radialbolzen (24) aufweist und die Saugnadelhalterung (5) mit einem Anschlag (25) versehen ist, wobei der Radialbolzen (24) in der waagrechten Stellung des Armes (6) an diesem Anschlag (25)anliegt.

9. Einrichtung nach einem oder mehreren der Ansprüche 1 bis 8, **dadurch gekennzeichnet, daß** die Saugnadelhalterung (5) in dem Arm (6) beweglich, gegen die Kraft einer Feder (16), gelagert ist.

10. Einrichtung nach einem oder mehreren der Ansprüche 1 bis 9, **dadurch gekennzeichnet, daß** die Saugnadelhalterung (5) in dem Arm (6) beweglich gelagert ist, wobei eine Feder (26) vorgesehen ist, die einerseits mit der Saugnadelhalterung (5) und anderseits mit dem Radialbolzen (24) verbunden ist.

11. Einrichtung nach einem oder mehreren der Ansprüche 1 bis 10, **dadurch gekennzeichnet, daß** die Feder (26) eine Zugfeder ist.

12. Einrichtung nach einem oder mehreren der Ansprüche 1 bis 11, **dadurch gekennzeichnet, daß** die Hohlwelle (19) entgegen der Kraft der Zugfeder (23) weiterverdrehbar ist.

## Claims

1. Device for positioning electronic circuits (1) arranged on a foil (2), in particular chips, on a circuit card, in particular on a ceramic substrate, using the flip-chip method, whereby the circuits are lifted from the foil by needles (4) located under said foil and are picked up by a needle with a suction cup (3) that rotates the chips by 180°, and are then received by another needle with a suction cup (10) and positioned on the circuit board for direct connection of the contact lines, **characterised by** the fact that both the lifting needles (4) for lifting the circuit (1) from the foil (2) and the needle with a suction cup (3) perform a synchronous, mainly rectilinear or vertical movement, that the needle with a suction cup (3) is placed in a holder (5) which is mounted in an arm (6) so as to be capable of movement, and this arm (6) is driven by a drive (9) in order to carry out the 180° rotation movement, and that the additional needle with a suction cup (10) is also arranged in a holder (12) that provides the needle with a suction cup (12) with four degrees of freedom, namely along the axes x, y, z and rotation.

2. Device in accordance with Claim 1, **characterised by** the fact that there are two stereometric cameras (13, 14), whereby one stereometric camera (14) is used to measure the circuit card and the second stereometric camera (13) is used to measure the circuit (1), and both stereometric cameras (13, 14) are connected to a computer (15), and calibration of the two stereometric cameras (13, 14) is performed by overlaying the two images until they match, and that this calibrated position can be stored in the computer (15).

3. Device in accordance with Claim 2, **characterised by** the fact that the computer (15) can after measuring a circuit (1) calculate or detect any deviation from the calibrated position and control the second needle with a suction cup (10) according to the difference.

4. Device in accordance with one or more of Claims 1 to 3, **characterised by** the fact that a stepper motor is provided as a drive (9) for the 180° rotation movement of the arm (6).

5. Device in accordance with one or more of Claims 1 to 4, **characterised by** the fact that the arm (6) is arranged radially on a shaft (18), whereby this shaft (18) is placed in a tubular shaft (19) and the tubular shaft (19) is fitted with a slit (20) for the arm (6) to pass through, with an angle greater than 180°, preferably 191°, and the tubular shaft (19) is driven the stepper motor via a belt drive (8).

6. Device in accordance with one or more of Claims 1 to 5, **characterised by** the fact that both the shaft (18) and the tubular shaft (19) have a radial bolt (21, 22), whereby the bolt (21) of the shaft (18) passes through the slit (20) or a hole in the tubular shaft (19), and the two bolts (21, 22) are connected by a tension spring (23).

7. Device in accordance with one or more of Claims 1 to 6, **characterised by** the fact that the radial arm (6) placed on the shaft (18) performs a precise 180° rotation movement limited by stoppers (17).

8. Device in accordance with one or more of Claims 1 to 7, **characterised by** the fact that the tubular shaft (19) has a further radial bolt (24), and the holder (5) is fitted with a stopper (25), whereby the radial bolt (24) lies against this stopper (25) when the arm (6) is in horizontal position.

9. Device in accordance with one or more of Claims 1 to 8, **characterised by** the fact that the holder (5) is placed in the arm (6) so as to be capable of movement against the force of a spring (16).

10. Device in accordance with one or more of Claims 1 to 9, **characterised by** the fact that the holder (5) is placed in the arm (6), whereby a spring (26) is provided which is connected on the one hand to the holder (5) and on the other hand to the radial bolt (24).

11. Device in accordance with one or more of Claims 1 to 10, **characterised by** the fact that the spring (26) is a tension spring.

12. Device in accordance with one or more of Claims 1 to 11, **characterised by** the fact that the tubular shaft (19) can be further rotated against the force of the tension spring (23).

## Revendications

1. Dispositif de positionnement de circuits électroniques (1) agencés sur un film (2), notamment de puces électroniques, sur une carte de circuits imprimés, notamment sur un substrat céramique, suivant la méthode Flip-Chip, les circuits étant soulevés du film par des aiguilles de perçage (4) agencées sous le film et saisis par une aiguille aspirante (3) et pivotés de 180°, repris par une autre aiguille aspirante (10) et positionnés sur la carte de circuits imprimés pour une liaison directe des voies de contact, **caractérisé en ce que** tant les aiguilles de perçage (4) pour soulever les circuits (1) du film (2) que l'aiguille aspirante (3) pour la reprise exécutent un mouvement vertical synchrone, notamment en ligne droite, que l'aiguille aspirante (3) est prévue dans un support d'aiguille aspirante (5), logé de façon mobile dans un bras (6) et que ce bras (6) peut être mû via un entraînement (9) pour le mouvement rotatif de 180°et que l'autre aiguille aspirante (10) est également logée dans un support d'aiguille aspirante (12) qui accorde à l'aiguille aspirante (10) quatre libertés de mouvement, à savoir dans les sens x, y et z, et une rotation.

2. Dispositif selon la revendication 1, **caractérisé en ce que** deux chambres stéréométriques (13, 14) sont prévues, une chambre stéréométrique (14) servant à la mesure de la carte de circuits imprimés (11) et la deuxième chambre stéréométrique (13) servant à la mesure des circuits (1), et les deux chambres stéréométriques (13, 14) étant raccordées à un ordinateur (15), et l'étalonnage des deux chambres stéréométriques (13, 14) se faisant par fondu-enchaîné jusqu'à coïncidence totale des deux images, et cette position étalonnée étant enregistrable dans l'ordinateur (15).

3. Dispositif selon la revendication 2, **caractérisé en ce que** l'ordinateur (15) calcule et/ou détermine, après le mesurage de circuits (1), une éventuelle déviation de la position étalonnée, et pilote l'autre aiguille aspirante (10) conformément à la différence.

4. Dispositif selon une ou plusieurs des revendications 1 à 3, **caractérisé en ce qu'**il est prévu un moteur pas à pas comme entraînement (9) pour le mouvement rotatif 180° du bras (6).

5. Dispositif selon une ou plusieurs des revendications 1 à 4, **caractérisé en ce que** le bras (6) est agencé de façon radiale sur un arbre (18), cet arbre (18) étant logé dans un arbre creux (19) concentrique et l'arbre creux (19) étant pourvu d'une fente (20) pour le passage du bras (6), qui présente un angle supérieur à 180°, de préférence 191°, et que l'arbre creux (19) peut être entraîné via une commande à courroie (8) par le moteur pas à pas.

6. Dispositif selon une ou plusieurs des revendications 1 à 5, **caractérisé en ce que** tant l'arbre (18) que l'arbre creux (19) présentent un boulon axial (21, 22), le boulon (21) de l'arbre (18) dépassant par une fente (20) ou un creux dans l'arbre creux (19) et ces deux boulons (21, 22) étant reliés l'un à l'autre par un ressort de traction (23).

7. Dispositif selon une ou plusieurs des revendications 1 à 6, **caractérisé en ce que** le bras radial (6) agencé sur l'arbre (18) exécute un mouvement rotatif d'exactement 180° limité par des butées (17).

8. Dispositif selon une ou plusieurs des revendications 1 à 7, **caractérisé en ce que** l'arbre creux (19) présente un autre boulon radial (24) et que le support d'aiguille aspirante (5) est pourvu d'une butée (25), le boulon radial (24) étant appliqué contre cette butée (25) dans la position horizontale du bras (6).

9. Dispositif selon une ou plusieurs des revendications 1 à 8, **caractérisé en ce que** le support d'aiguille aspirante (5) est logé, de façon mobile, dans le bras (6), contre la force d'un ressort (16).

10. Dispositif selon une ou plusieurs des revendications 1 à 9, **caractérisé en ce que** le support d'aiguille aspirante (5) est logé, de façon mobile, dans le bras (6), un ressort (26) étant prévu, qui est relié d'une part au support d'aiguille aspirante (5) et d'autre part au boulon radial (24).

11. Dispositif selon une ou plusieurs des revendications 1 à 10, **caractérisé en ce que** le ressort (26) est un ressort de traction.

12. Dispositif selon une ou plusieurs des revendications 1 à 11, **caractérisé en ce que** l'arbre creux (19) peut continuer à être tourné contre la force du ressort de traction (23).
